# EUROPEAN PATENT APPLICATION

(11) **EP 2 184 954 A1**
(43) Date of publication of application: **12.05.2010**
(21) Application number: 08791547.6
(22) Date of filing: 24.07.2008
(51) Int. Cl.: H05B 33/12, H01L 51/50, H05B 33/04, H05B 33/10

(54) **LIGHT EMITTING ELEMENT, LIGHT EMITTING ELEMENT MANUFACTURING METHOD AND ILLUMINATING DEVICE**

(30) Priority: 31.07.2007 JP 2007199909
(71) Applicant: Sumitomo Chemical Company, Limited, Tokyo 104-8260 (JP)
(72) Inventor: TANAKA, Shin-ya, Tsukuba-shi Ibaraki 305-0047 (JP); MORISHIMA, Shinichi, Tsukuba-shi Ibaraki 305-0047 (JP)
(74) Representative: Winter, Brandl, Fürniss, Hübner Röss, Kaiser, Polte Partnerschaft Patent- und Rechtsanwaltskanzlei
(86) International application number: PCT/JP2008/063295
(87) International publication number: WO 2009/017029

(57) **Abstract**

The light-emitting element according to the present invention is **characterized in that**: the light-emitting element comprises a light-emitting layer that is sealed at a light extracting side with a multilayer sealing film and the multilayer sealing film includes at least one color conversion layer. Then, the method for producing the light-emitting element according to the present invention is **characterized in that**: the method for producing a light-emitting element that has a light-emitting layer sealed at a light extracting side with a multilayer sealing film, comprises forming at least one color conversion layer in a formation of the multilayer sealing film. The light-emitting element according to the present invention incorporates a function of controlling color conversion of its extracted light without increasing a occupied space for the element.

## Description

### TECHNICAL FIELD

The present invention relates to a light-emitting element typified by an organic electroluminescence element (hereinafter, the organic electroluminescence element is also referred to as the organic EL element), a method for producing the same, and an illuminating device using the same. More particularly, the present invention relates to a light-emitting element that can implement color conversion of the extracted light by providing a color conversion layer in a multilayer sealing film that seals the light-emitting layer of the element, a method for producing the same, and an illuminating device using the same.

### BACKGROUND ART

In light-emitting elements such as an organic EL element or a light-emitting diode display element, a light-emitting layer held between an anode and a cathode is formed on a substrate and a multilayer sealing film is formed thereon to cover this light-emitting layer. A glass substrate has been used for the substrates of the conventional light-emitting elements; however, the use of a plastic substrate has begun to meet demands for such as weight reduction of elements, improvement of impact resistance, producing an large area element or improvement of productivity (e.g., Patent Document 1).

The plastic substrate is flexible, and the one having large area is easily available. In addition, the plastic substrate facilitates the cutting-process to cut into an element unit after forming the light-emitting layer. However, permeability to gases and liquids of the plastic substrate is high compared with the glass substrate. Display materials in an organic EL light-emitting layer enclosed with the plastic substrate and an upper multilayer sealing film are easily oxidized and are easily deteriorated by contact with water. Therefore, when the plastic substrate is employed, a lower multilayer sealing film having a high barrier property for gases and liquids is formed on the substrate, and subsequently, the light-emitting layer is formed on this lower multilayer sealing film, and then the upper multilayer sealing film is formed thereon to cover the stacked light-emitting layer.

The lower multilayer sealing film is usually formed by using the same constitution and the same materials as those of the upper multilayer sealing film. The lower multilayer sealing film and the upper multilayer sealing film usually have at least one inorganic layer and at least one organic layer. The number of layers to be stacked is determined as needed, and the inorganic layer and the organic layer are basically stacked alternately.

Light extraction from the light-emitting element is implemented from a substrate side, from an upper multilayer sealing film side or from both of the substrate side and the upper multilayer sealing film side. The light-emitting element in which the light is extracted from the substrate side is referred to as the bottom emission type of light-emitting element. The light-emitting element in which the light is extracted from the upper multilayer sealing film side is referred to as the top emission type of light-emitting element. The light-emitting element in which the light is extracted from the both sides is referred to as the dual emission type of light-emitting element. Among these types, it is commonly said that the multilayer sealing film on a light extracting side must be light-transmittable; as the result, the efficiency of the light extraction is affected by the physical properties of the multilayer sealing film. For this reason, with regard to the conventional light-emitting element, the multilayer sealing film on the light extracting side is composed to be transparent and flat as much as possible.

Patent Document 1: JP 2003-531745 A

### DISCLOSURE OF INVENTION

### PROBLEM TO BE SOLVED BY THE INVENTION

In some cases the color of the extracted light has to be changed depending on the purposes of the devices to which a light-emitting element is mounted, such as an illuminating device, a display device or an electronic instrument, and especially such demand is needed for the illuminating device. To meet such case, various optical elements for color conversion, such as a colored plate in front of a light extracting face of the light-emitting element, are provided. However, as the result of having additional optical elements, the device using such the light-emitting elements is required to have more spaces occupied with the additional elements. Moreover, the required spaces tend to cause a bottleneck in downsizing device. Therefore, the solution for this problem has been required.

The present invention has been developed in consideration of the above circumstances, and an object of the present invention is to provide a light-emitting element incorporating a function of color conversion of the extracted light without increasing a occupied space with the element.

### MEANS FOR SOLVING PROBLEM

The present invention provides a light-emitting element, a method for producing the same and a illuminating device using the same, by employing the following components.

[1] A light-emitting element comprising a multilayer sealing film and a light-emitting layer that is sealed at a light extracting side thereof with the multilayer sealing film,
   wherein the multilayer sealing film includes at least one color conversion layer.
[2] The light-emitting element according to the above [1], wherein the multilayer sealing film includes at least one organic layer.
[3] The light-emitting element according to the above [1] or [2], wherein the multilayer sealing film includes at least one first film and at least one second film.
[4] The light-emitting element according to the above [3], wherein the color conversion layer is formed between the at least one first film and the least one second film.
[5] The light-emitting element according to any one of the above [1] to [4], wherein the color conversion layer comprises a matrix material and a color conversion material contained in the matrix material.
[6] The light-emitting element according to the above [5], wherein the color conversion layer is the at least one first film containing the color conversion material.
[7] The light-emitting element according to the above [5] or [6], wherein a content of the color conversion material in the color conversion layer is 0.01% to 90% by weight.
[8] The light-emitting element according to the above [1] to [4], wherein the color conversion layer consist of a color conversion material.
[9] The light-emitting element according to the above [5], wherein the color conversion material is composed of at least one selected from the group consisting of an inorganic phosphor, an organic pigment and a coloring matter.
[10] The light-emitting element according to the above [8], wherein the color conversion material is composed of at least one selected from the group consisting of an inorganic phosphor, an organic pigment and a coloring matter.
[11] The light-emitting element according to the above [3] to [10], wherein the first film is an organic film.
[12]The light-emitting element according to the above [11], wherein the organic film is composed of an acrylic polymer.
[13] The light-emitting element according to any one of the above [3] to [12], wherein the second film is an inorganic film.
[14] The light-emitting element according to the above [1] to [13], which is an organic EL element.
[15] An illuminating device comprising the light-emitting element which is the organic EL element according to the above [14].
[16] A method for producing a light-emitting element that has a light-emitting layer sealed at a light extracting side thereof with a multilayer sealing film, the method comprising:
   forming at least one color conversion layer in a formation of the multilayer sealing film.
[17] The method for producing the light-emitting element according to the [16], wherein the multilayer sealing film includes at least one organic layer.
[18] The method for producing the light-emitting element according to the above [16] or [17], wherein the multilayer sealing film is formed configured to include at least one first film and at least one second film.
[19] The method for producing the light-emitting element according to the above [18], wherein the color conversion layer is formed between the at least one first film and at least one second film.
[20] The method for producing the light-emitting element according to any one of the above [16] to [19], wherein the color conversion layer is formed by containing a color conversion material in a matrix material of the color conversion layer.
[21] The method for producing the light-emitting element according to the above [20], wherein the color conversion layer is formed by containing the color conversion material at least in the one first film.
[22] The method for producing the light-emitting element according to the above [20] or [21], wherein an content amount of the color conversion material in the color conversion layer is adjusted within the range of 0.01% to 90% by weight in an entire amount of the color conversion layer.
[23] The method for producing the light-emitting element according to any one of the above [16] to [19], wherein the color conversion layer is formed from a color conversion material.
[24] The method for producing the light-emitting element according to any one of the above [20] to [22], wherein the color conversion material is at least one selected from the group consisting of an inorganic phosphor, an organic pigment and a coloring matter.
[25] The method for producing the light-emitting element according to the above [23], wherein the color conversion material is at least one selected from the group consisting of an inorganic phosphor, an organic pigment and a coloring matter.
[26] The method for producing the light-emitting element according to any one of the above [18] to [25], wherein the first film is an organic film.
[27] The method for producing the light-emitting element according to the above [26], wherein the organic film is formed from an acrylic polymer.
[28] The method for producing the light-emitting element according to any one of the above [18] to [27], wherein the second film is an inorganic film.
[29] The method for producing the light-emitting element according to the above [16] to [28], wherein the light-emitting element is an organic EL element.

### EFFECT OF THE INVENTION

According to the present invention of the light-emitting element, the light-emitting element per se emits the light of desired color without adding extra optical elements. Such function and effect can be obtained by forming at least one color conversion layer in a multilayer sealing film at the light extracting side. Since this color conversion layer is formed by containing a color conversion material in its matrix material, the layer can be easily formed as one layer in the multilayer sealing film. The organic layer per se which constitutes the multilayer sealing film may be used as the matrix material of the color conversion layer, or an organic compound that newly forms a layer may be used; therefore, it is easy to form the color conversion layer. In the conventional method using a colored optical film, an advanced laminating step and an optical film member are needed. However, according to the production method of the present invention, the color conversion layer can be formed in the ordinary process of forming the multilayer sealing film; therefore, the process is simple and it is possible to easily produce a light-emitting element from which the desired colored light can be extracted.

Therefore, the light-emitting element and the method for producing the same of the present invention can inexpensively provide a light-emitting element from which the desired colored light can be extracted without increasing the occupied space thereof.

### BEST MODES FOR CARRYING OUT THE INVENTION

Embodiments of the light-emitting element and the production method for producing the same of the present invention are described below.
The light-emitting element of the present embodiment is characterized by comprising a multilayer sealing film including at least one organic layer and a light-emitting unit that is sealed at a light extracting side thereof with the multilayer sealing film, and including at least one color conversion layer in the multilayer sealing film.

The method for producing the light-emitting element of the present embodiment is characterized as a method for producing a light-emitting element that has a light-emitting layer sealed at a light extracting side thereof with a multilayer sealing film, the method comprising forming at least one color conversion layer in a formation of the multilayer sealing film.

The color conversion layer used in the present embodiment may contain a color conversion material in its matrix material or may be made from the color conversion material. When the color conversion layer is made from the color conversion material, it is preferable that a first film and a second film are inorganic films and the color conversion layer is provided between these films.

The color conversion layer is formed by containing in the matrix material the color conversion material that absorbs the light at a certain wavelength. Thus, it becomes possible to extract various colored lights by appropriately selecting the color conversion materials. Some types of the color conversion materials may be mixed in one layer or may be separately contained in the some layers. White light can also be extracted from the light-emitting element by mixing the emitted light from the light-emitting layer with the emitted light whose color has been converted by the color conversion material. The light-emitting element from which such white light can be extracted is suitable as a light source of illuminating devices.

As mentioned in the above, the color conversion layer is formed by containing the color conversion material that absorbs the light at the certain wavelength in the matrix materia; therefore, the color conversion layer can be easily formed as one layer in the multilayer sealing film. As the matrix material of this color conversion layer, the organic layer per se that forms the multilayer sealing film may be used or an organic compound that newly forms the layer may be used.

The color conversion material contained in the color conversion layer is preferably mixed uniformly. This color conversion material may be contained to be completely dissolved in the color conversion layer, or the color conversion material may be made into particulates and then this particulate color conversion material is uniformly dispersed in the color conversion layer. In this way, the light from the light-emitting unit to the outside can be converted to the desired colored light, and additionally the light can be scattered by the colored particles, thereby making it possible to control the direction dependency of an extracted colored light intensity. The matrix material of the color conversion layer is composed of the same material as or the similar material to a constituent material of the organic layer that forms the multilayer sealing film.

An amount of the color conversion material to be added in the color conversion layer is preferably adjusted within a range of 0.01% to 90% by mass based on the entire amount of the color conversion layer. When the amount is less than 0.01% by mass, a target refractive index can not be controlled, and when the amount exceeds 90% by mass, a film strength in the color conversion layer is deteriorated in some cases, which are not preferable. When the color conversion material is used in the form of fine particles, an upper limit of the content is preferably set to 80% by mass or less because the film strength is greatly affected by the fine particles. An average particle diameter varies depending on a required level of the control of the refractive index and the foregoing amount to be added; thus, it can not be determined consistently and is preferably adjusted within the range of 0.05 µm to 1 µm.

When the color conversion material mixed in the organic layer that is the matrix material of the color conversion layer is in the form of fine particulates, it is preferable to be dispersed uniformly in the layer. The fine particulates of the color conversion material mixed in the organic layer may be dispersed only inside the layer not to disturb an interface of the organic layer, or may be dispersed configured to stick out from the interface and make unevenness on the interface. The refractive index is further controlled by making the unevenness on the interface of the organic layer; therefore, it is preferable from the point of view of making it possible to improve controllability of the overall refractive index.

In the present embodiment, the color conversion layer is formed in the multilayer sealing film layer; thus, the color conversion layer may be formed in the lower multilayer sealing film, and also, may be formed in the upper multilayer sealing film. Therefore, the light-emitting element of the present invention may be applied to the top emission type of light-emitting element, the bottom emission type of light-emitting element and the dual emission type of light-emitting element.

The structures and the constituent materials of the multilayer sealing film and the constituent materials of the color conversion layer, which form the light-emitting element of the present embodiment, are described below.
As for the layers used in the multilayer sealing film of the present embodiment, the layer composed of an organic film is referred to as the organic layer, and the layer composed of an inorganic film is referred to as the inorganic layer.

In the present embodiment, the lower multilayer sealing film formed on a substrate may be formed directly on the substrate or may be formed on some intermediate layer. Examples of such intermediate layers may include lyophilic layers that make a substrate surface lyophilic. Such formation of making direct or indirect is also employed in the formation of "lower multilayer film-light-emitting layer-upper multilayer sealing film" in the light-emitting element of the present invention. That is, the light-emitting layer may be formed directly or indirectly on the lower multilayer sealing film. Likewise, the upper multilayer sealing film which is formed on the light-emitting layer may be formed directly or indirectly on the light-emitting layer. An example of a stacked structure of an organic EL element is given as following: a multilayered structure such as flexible substrate/ (organic/inorganic) lower multilayer film/ anode (e.g., ITO)/ hole injection layer (e.g., MoO₃ film/poly(3,4)-ethylenedioxythiophene/polystyrene sulfonic acid film)/polymer organic light-emitting material layer/ electron injection layer (e.g., Ba film)/ cathode (e.g., Al film)/(organic/inorganic) upper multilayer sealing film.

A thickness of the organic layer and the inorganic layer that compose the lower and upper multilayer sealing films is preferably in the range of 50 angstroms to 10 µm. When the thickness is less than 50 angstroms, it becomes difficult to keep a mechanical property of the film well. When the thickness exceeds 10 µm, an entire thickness becomes thickened, and in some cases the light extracting efficiency from the light-emitting layer is affected in the organic EL elements and the like.

### (Constituent materials of lower and upper multilayer sealing films)

Preferred example for the inorganic layer that constitutes the lower and upper multilayer sealing films may include materials such as silicon oxide (SiO2), silicon nitride (SiN), silicon oxynitride (SiON) and aluminium oxide (Al₂O₃) are suitably used. As the method of forming this inorganic film, publicly known methods for forming a thin film such as a sputtering method and a plasma CVD method may be used.

The abovementioned sputtering method refers to one of methods for forming a thin film, which fine particles having an atomic or molecular size are collided with a target material (material of thin film) and the target material as fine particles is released into gas phase and the fine particles of the target material are accumulated onto a predetermined substrate surface, thus finally forming the thin film. In some cases, colliding fine particles having an atomic or molecular size with a target material to release fine particles of the target material may be referred to as "sputtering."
The CVD (Chemical Vapor Deposition) method is one of the methods for forming the thin film, which a raw material gas containing a constituent element of the thin film is supplied into a reaction chamber and energy such as heat or plasma is applied to cause a chemical reaction and a reaction product is accumulated onto the substrate surface.

Meanwhile, as the organic layer that composes the lower and upper multilayer sealing films, acrylic polymers obtained by polymerizing (meth)acrylic acid compounds, that is, a organic monomers having a (meth)acrylic group(s) and showing a good adhesiveness to the inorganic layer material are mainly and suitably used.
The (meth)acrylic compounds refer to compounds that contain a structural unit such as acrylic acid, methacrylic acid and esters thereof.

The (meth)acrylic compound is made into a coating film by a publicly known method for forming the coating film, such as a solution application method and a spray application method, and the coating film is polymerized by irradiating with optical energy (chemical beams such as electron beam, plasma beam and ultraviolet ray) or applying heat energy, thus obtaining the acrylic polymer.

The (meth)acrylic compound is not particularly limited, and it is sufficient to be a compound containing one or more (meth)acrylic groups in the molecule. When the compound contains one (meth)acrylic group, the high adhesiveness to the inorganic layer can be obtained. When the compound contains two or three (meth)acrylic groups, a crosslinking density becomes high and the film strength of the organic layer is enhanced.

Examples of the (meth)acrylic compound may include: compounds having hydroxyl group such as 2-hydroxyethyl (meth)acrylate, 2-hydroxypropyl (meth)acrylate and 2-hydroxybutyl (meth)acrylate;
compounds having amino group such as dimethylaminoethyl (meth)acrylate and diethylaminoethyl (meth)acrylate; compounds having carboxylic group such as (meth)acrylic acid, 2-(meth)acryloisooxyethylsuccinic acid and 2-(meth)acryloyloxyethyl hexahydrophthalic acid;
(meth)acrylates having a cyclic skeleton such as glycidyl (meth)acrylate, tetrahydrofrufryl (meth)acrylate, cyclohexyl (meth)acrylate, phenoxyethyl (meth)acrylate and isobonyl (meth)acrylate;
monofunctional acrylic compounds such as isoamyl (meth)acrylate, lauryl (meth)acrylate, stearyl (meth)acrylate, butoxyethyl (meth)acrylate, ethoxydiethylene glycol (meth)acrylate, methoxytriethylene glycol (meth)acrylate and methoxydipropylene glycol (meth)acrylate;
difunctional acrylic compounds such as diethylene glycol di(meth)acrylate, 1,4-butanediol di(meth)acrylate, 1,6-hexanediol di(meth)acrylate, 1,9-nonanediol di(meth)acrylate, triethylene di(meth)acrylate, PEG#200 di(meth)acrylate, PEG#400 di(meth)acrylate, PEG#600 di(meth)acrylate, neopentyl di(meth)acrylate and dimethyloltricyclodecane di(meth)acrylate; and difunctional (meth)acrylic compounds such as difunctional epoxy (meth)acrylate and difunctional urethane (meth)acrylate. Usable compounds having three or more (meth)acrylic acids may include: multifunctional acrylic monomers such as dipentaerythritol hexa(meth)acrylate, pentaerythritol tri(meth)acrylate, pentaerythritol tetra(meth)acrylate, trimethylolpropane triacrylate and trimethylolpropane tetraacrylate; (meth)acrylic multifunctional epoxy acrylate; and (meth)acrylic multifunctional urethane acrylate.

### (Color conversion material used for color conversion layer)

The color conversion material has the function of absorbing the light emitted from the light-emitting layer and generating a light emitting with a longer wavelength. Examples of color conversion materials may include inorganic phosphors, organic pigments and coloring matters. These color conversion materials may be used alone or in mixture with a resin. A material that the color conversion material has been dissolved or dispersed in a binder resin may also be included.

Examples of the above coloring matters may include fluorescent coloring matters, such as stilbene-based coloring matters, coumarin-based coloring matters, naphthalimide coloring matters, pyridine-based coloring matters and rhodamine-based coloring matters. The above pigments include various dyes (such as direct dyes, acid dyes, basic dyes, dispersion dyes) having fluorescence. As the above fluorescent coloring matters, those being incompatible with the material that forms the organic layer in the sealing film may be used without problems if those are able to be dispersed homogenously. In such a case, a dispersion aid may also be combined.

As the inorganic phosphor, an inorganic phosphor fine particle having a small particle diameter may also be used. The inorganic phosphor fine particles are composed of an inorganic compound of a metal compound, and its surface may be modified with an organic substance such as a long chain alkyl group and a phosphate group for enhancing a dispersibility with the material that forms the organic layer in the sealing film. As the fine particles that absorb and emit the visible light by using a band gap of semiconductors, semiconductor fine particles such as CdS, CdSe, ZnS, ZnSe and InP may also be used, and the semiconductor fine particles whose surface have been modified with a metal oxide such as a silica or an organic substance may also be used in order to prevent S or Se of such particles from being drawn due to a reaction component of the material that forms the organic layer in the sealing film.

### (Other additives)

In the color conversion layer (organic layer), the mechanical strength tends to be reduced by adding the color conversion material. Thus, as an additive for example multifunctional acrylate such as DPHA (dipentaerythritol hexaacrylate: hexafunctional acrylate), a fluorine substituent thereof, a multifunctional epoxy compound and a silane coupling agent may be used for enhancing the strength of the layer and the adhesiveness to the adjacent layer.

The sealing film may have an adhesiveness enhancement layer. The adhesiveness enhancement layer contains a material that enhances the adhesiveness, and the material enhancing the adhesiveness may include a crosslinked polymer compound and a silane coupling agent.

Examples of the crosslinked polymer compound may include compounds obtained by crosslinking and polymerizing a monomer compound (polymerizable compound) having a substituent polymerizable by applying heat or light energy or by the action of a heat polymerization initiator or an optical polymerization initiator. The polymerizable substituent (described as the crosslinking group in some cases) refers to a substituent that can form a bond between two or more molecules by a polymerization reaction to generate a compound. Examples of such crosslinking groups may include vinyl group, acetylene group, butenyl group, acrylic group, acrylate group, acrylamide group, methacrylic group, methacrylate group, methacrylamide group, vinylether group, vinylamino group, silanol group, groups having a small ring system (such as cyclopropyl group, cyclobutyl group, epoxy group, oxetane group, diketene group, and episulfide group), lactone group, lactam group, and groups containing a siloxane derivative.

Among addition to the above groups, the combination of the groups capable of forming an ester bond or an amide bond may also be used. For example, the combination of the ester group and the amino group and the combination of the ester group and the hydroxyl group are available.

In the abovementioned materials, in particular, the monomer having the (meth)acrylate group is preferable. Specific examples of monofunctional monomers having the (meth)acrylate group may include 2-ethylhexylcarbitol acrylate and 2-hydroxyethyl acrylate. Specific examples of a difunctional monomer having the (meth)acrylate groups may include 1,6-hexanediol di(meth)acrylate, ethylene glycol di(meth)acrylate, neopentyl glycol di(meth)acrylate, triethylene glycol di(meth)acrylate and 3-methylpentanediol di(meth)acrylate. Specific examples of the other multifunctional monomers having the (meth)acrylate group may include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate and tris pentaerythritol octa(meth)acrylate. Among them, difunctional or more, preferably pentafunctional or more and more preferably octafunctional or more multifunctional monomers are excellent in curable property and adhesiveness, thus preferably being used. The "number of -functional" of monomers referred to here means the "number of the crosslinking groups." That is, the functional group in the multifunctional monomer means the crosslinking group that the monomer has.

The crosslinking agents used for the polymerization are described, for example, in Photopolymer Handbook, pages 17 to 56 (published by Kogyo Chosakai Publishing Co., Ltd., 1989).

When the aforementioned material has a fluorine atom(s), the water-repellent effect also works and then the barrier property of the sealing film can be enhanced.

The above silane coupling agent is the material that exhibits a physical adsorption property on the interface. The silane coupling agents used in the present embodiment are not particularly limited, and publicly known silane coupling agents may be used.

The light-emitting element and the method for producing the light-emitting element according to the present embodiment are particularly useful when the light-emitting element is applied to the organic EL element. The formation of the multilayer sealing film described in detail above is the same as in such an organic EL element. Therefore, the other major members such as the substrate and the light-emitting layer of the organic EL element to which the present embodiment can be applied suitably are described in detail below.

### (Substrate)

The substrate used in the organic EL element is not particularly limited as long as the material is not changed when the electrode is formed and the layer of the organic material is formed. Usable examples may include a glass, a plastic, a polymer film, a silicon substrate or a laminate thereof.

### (Electrode and light-emitting layer)

A basic structure of the organic EL element employs at least one light-emitting layer between electrodes composed of a pair of an anode (first electrode) and a cathode (second electrode) in which at least the cathode has a light transmissive property. Low molecular and/or high molecular of organic light-emitting materials are used for the light-emitting layer.

Components around the light-emitting layer in the organic EL element may include the layers provided between the cathode and the light-emitting layer and the layers provided between the anode and the light-emitting layer in addition to the cathode, the anode and the light-emitting layer. The layers provided between the cathode and the light-emitting layer may include an electron injection layer, an electron transport layer and a hole block layer.

The electron injection layer is the layer having the function of improving an electron injection efficiency from the cathode. The electron transport layer is the layer having the function of improving an electron injection from the electron injection layer or the electron transport layer closer to the cathode (when the electron transport layer is composed of two or more layers). When the electron injection layer or the electron transport layer has the function of blocking the transport of holes, these layers may be referred to as the hole block layer.
It is possible to confirm that a layer has the function of blocking the transport of holes, for example, by making an element that runs a hole current alone and confirming the effects through reduction of its current value.

The layers provided between the anode and the light-emitting layer include a hole injection layer, a hole transport layer and an electron block layer.

The hole injection layer is the layer having the function of improving a hole injection efficiency from the cathode. The hole transport layer is the layer having the function of improving a hole injection from the hole injection layer or the hole transport layer closer to the anode (when the hole transport layer is composed of two or more layers). When the hole injection layer or the hole transport layer has the function of blocking the transport of electrons, these layers may be referred to as the electron block layer. It is possible to confirm that a layer has the function of blocking the transport of electrons, for example, by making an element that runs an electron current alone and confirming the effects through reduction of its current value.

Various combination of members organizing around the light-emitting layer in the above may include the formation in which the hole transport layer is provided between the anode and the light-emitting layer, the formation in which the electron transport layer is provided between the cathode and the light-emitting layer, and the formation in which the electron transport layer is provided between the cathode and the light-emitting layer and the hole transport layer is provided between the anode and the light-emitting layer. Specifically, the following structures a) to d) are shown as examples.
a) anode/light-emitting layer/cathode
b) anode/hole transport layer/light-emitting layer/cathode
c) anode/light-emitting layer/electron transport layer/cathode
d) anode/hole transport layer/light-emitting layer/electron transport layer/cathode

### (Here, symbol "/" indicates that the layers are adjacent to each other and stacked. The same applies hereinafter.)

Here, the light-emitting layer is the layer having the function of emitting the light as described in the above. The hole transport layer is the layer having the function of transporting the holes. The electron transport layer is the layer having the function of transporting the electrons. The electron transport layer and the hole transport layer are collectively referred to as the charge transport layer. Each of the light emitting layer, the hole transport layer, and the electron transport layer may independently employ two or more layers. Among the charge transport layers provided adjacent to the electrode, those layers having the function of improving the charge injection efficiency from the electrode and having the effect of reducing a driving voltage of the element are generally referred to as the charge injection layer (hole injection layer, electron injection layer) particularly.

Further, the charge injection layer or an insulation layer having a film thickness of 2 nm or less may be provided adjacent to the electrodes in order to enhance the adhesiveness to the electrode and improve the charge injection from the electrode. In addition, a thin buffer layer may be inserted in the interface of the charge transport layer or the light-emitting layer in order to enhance the adhesiveness of the interface and prevent a blend. An order and the number of the layers to be formed and the thickness of each layer may be appropriately determined by taking a light-emitting efficiency or an element lifetime into consideration.

Examples of the organic EL element in which the charge injection layer (the electron injection layer, the hole injection layer) is provided may include the organic EL element in which the charge injection layer is adjacently provided to the cathode, and the organic EL element in which the charge injection layer is adjacently provided to the anode. Specifically, the following structures e) to p) are shown as examples.
e) anode/charge injection layer/light-emitting layer/cathode
f) anode/light-emitting layer/charge injection layer/cathode
g) anode/charge injection layer/light-emitting layer/charge injection layer/cathode
h) anode/charge injection layer/hole transport layer/light-emitting layer/cathode
i) anode/hole transport layer/light-emitting layer/charge injection layer/cathode
j) anode/charge injection layer/hole transport layer/light-emitting layer/charge injection layer/cathode
k) anode/charge injection layer/light-emitting layer/charge transport layer/cathode
l) anode/light-emitting layer/charge transport layer/charge injection layer/cathode
m) anode/charge injection layer/light-emitting layer/electron transport layer/charge injection layer/cathode
n) anode/charge injection layer/hole transport layer/light-emitting layer/charge transport layer/cathode
o) anode/hole transport layer/light-emitting layer/electron transport layer/charge injection layer/cathode
p) anode/charge injection layer/hole transport layer/light-emitting layer/electron transport layer/charge injection layer/cathode

In the examples of the layered structures indicated in (a) to (p), any structure in which the anode is provided at the side closer to the substrate, or in which the cathode is provided at the side closer to the substrate, may be employed.

### (Anode)

For the anode, for example, a thin film formed of a metal oxide, metal sulfide, or metal having high electric conductivity may be used as a transparent electrode, and the anode having a high transparency may be suitably utilized, and it is appropriately selected and used depending on the organic layer to be used. Examples may include indium oxide, zinc oxide, tin oxide, and indium tin oxide (ITO) which is a complex thereof, and a film (NESA and the like) which is made using an electric conductive film comprising indium tin oxide, as well as gold, platinum, silver and copper, and ITO, indium zinc oxide and tin oxide are preferable. The method of producing the anode may include a vacuum deposition method, a sputtering method, an ion plating method and a plating method. As the anode, an organic transparent conductive film such as polyaniline or a derivative thereof or polythiophene or a derivative thereof may also be used.

The film thickness of the anode may be appropriately selected in consideration of the light transparency and the electric conductivity, and is for example 10 nm to 10 µm, preferably 20 nm to 1 µm and more preferably 50 nm to 500 nm.

### (Hole injection layer)

The hole injection layer may be provided between the anode and the hole transport layer or between the anode and the light-emitting layer as described above. The materials that form the hole injection layer may include phenylamine-based compounds, starburst type amine-based compounds, phthalocyanine-based compounds, oxides such as vanadium oxide, molybdenum oxide, ruthenium oxide and aluminium oxide, amorphous carbon, polyaniline and polythiophene derivatives.

### (Hole transport layer)

Examples of materials to form the hole transport layer, may include polyvinylcarbazole or derivatives thereof, polysilane or derivatives thereof, polysiloxane derivatives having aromatic amine in the side chain or the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylene vinylene) or derivatives thereof, or poly(2,5-thienylene vinylene) or derivatives thereof.

Among them, preferred examples of the hole transport materials to be used for the hole transport layer may include polymer hole transport materials such as polyvinylcarbazole or the derivatives thereof, polysilane or the derivatives thereof, the polysiloxane derivatives having an aromatic amine group in the side chain or the main chain, polyaniline or the derivatives thereof, polythiophene or the derivatives thereof, polyarylamine or the derivatives thereof, poly(p-phenylene vinylene) or derivatives thereof, and poly(2,5-thienylene vinylene) or the derivatives thereof, and more preferably, examples may include polyvinylcarbazole or the derivatives thereof, polysilane or the derivatives thereof and the polysiloxane derivatives having aromatic amine group in the side chain or the main chain are used for the hole trans port material for the hole transport layer. When the hole transport material is a low molecule, it is preferable to use the material by being dispersed in a polymer binder.

### (Light-emitting layer)

In the present embodiment, the light-emitting layer is an organic light-emitting layer, and generally contains an organic substance (low molecular compounds and polymer compounds) that emits mainly fluorescence or phosphorescence. It may further contain a dopant material. Usable examples of the material to forms the light-emitting layer in the present invention may include the following.

### (Light-emitting layer-forming material 1: coloring matter materials)

Examples of coloring matter materials may include cyclopendamine derivatives, tetraphenylbutadiene derivative compounds, triphenylamine derivatives, oxadiazole derivatives, quinacridone derivatives, coumarin derivatives, pyrazoloquinoline derivatives, distyrylbenzene derivatives, distrlylarylene derivatives, pyrrole derivatives, thiophene ring compounds, pyridine ring compounds, perinone derivatives, perylene derivatives, oligothiophene derivatives, trifumanylamine derivatives, oxadiazole dimers and pyrazoline dimers.

### (Light-emitting layer-forming material 2: metal complex materials)

Examples of metal complex materials may include metal complexes emitting from a triplet excited state such as iridium complexes and platinum complexes; and metal complexes such as alumi-quinolinol complex, beryllium benzoquinolinol complex, zinc benzoxazolyl complex, zinc benzothiazole complex, zinc azomethyl complex, zinc porphyrin complex and europium complex, which have Al, Zn, Be, or a rare earth metal such as Tb, Eu or Dy as a center metal and have an oxadiazole, thiadiazole, phenylpyridine, phenylbenzimidazole or a quinoline structure as a ligand.

### (Light-emitting layer-forming material 3: polymer-based material)

Examples of polymer materials may include polyparaphenylene vinylene derivatives, polythiophene derivatives, polyparaphenylene derivatives, polysilane derivatives, polyacetylene derivatives, polyfluorene derivatives, polyvinylcarbazole derivatives, and polymerized products using the above coloring matters or the above metal complex materials.

Among the above light-emitting layer-forming materials, examples of materials that emit blue light may include distyrylarylene derivatives, oxadiazole derivatives and polymers thereof, polyvinylcarbazole derivatives, polyparaphenylene derivatives and polyfluorene derivatives. Among them, the polymer materials such as the polyvinylcarbazole derivatives, the polyparaphenylene derivatives and the polyfluorene derivatives are preferable.

Among the above light-emitting layer-forming materials, examples of materials that emit green light may include quinacridone derivatives, coumarin derivatives and polymers thereof, polyparaphenylene vinylene derivatives and polyfluorene derivatives. Among them, the polymer materials such as the polyparaphenylene vinylene derivatives and the polyfluorene derivatives are preferable.

Among the above light-emitting layer-forming materials, examples of materials that emit red light include coumarin derivatives, thiophene ring compounds and polymers thereof, polyparaphenylene vinylene derivatives, polythiophene derivatives and polyfluorene derivatives. Among them, the polymer materials such as the polyparaphenylene vinylene derivatives, the polythiophene derivatives and polyfluorene derivatives are preferable.

### (Light-emitting layer-forming material 4: dopant material)

A dopant may be added in the light-emitting layer for the purpose of enhancing the light-emitting efficiency and changing the wavelength of the light to be emitted. Examples of such dopants may include perylene derivatives, coumarin derivatives, rubrene derivatives, quinacridone derivatives, squarium derivatives, porphyrin derivatives, styryl-based coloring matters, tetracene derivatives, pyrazolone derivatives, decacyclene and phenoxazone.

### (Electron transport layer)

As the material that forms the electron transport layer, publicly known materials may be used, and examples may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof and polyfluorene or derivatives thereof.

Among them, preferred are oxadiazole derivatives, benzoquinone or the derivatives thereof, anthraquinone or the derivatives thereof, or the metal complexes of 8-hydroxyquinoline or derivatives thereof, polyquinoline or derivatives thereof, polyquinoxaline or derivatives thereof and polyfluorene or derivatives thereof, and more preferred are 2-(4-biphenylyl)-5-(4-t-butylphenyl)-1,3,4-oxadiazole, benzoquinone, anthraquinone, tris(8-quinolinol)aluminium and polyquinoline.

### (Electron injection layer)

As described previously, the electron injection layer is provided between the electron transport layer and the cathode or between the light-emitting layer and the cathode. Depending on the type of the light-emitting layer, as the electron injection layer, it is possible to provide an electron injection layer composed of a single layer structure of a Ca layer or an electron injection layer consisting of a stacked structure that is composed of a Ca layer and a layer formed from one or more selected from metals other than Ca classified in Groups 1 and 2 in the periodic table (employed by IUPAC [International Union of Pure and Applied Chemicals]) and having a work function of 1.5 to 3.0 eV, and an oxide, a halide of the metal and a carbonate of the above mentioned metals. Examples of the metals classified in Group 1 of the periodic table and having a work function of 1.5 to 3.0 eV, oxides, halides, or carbonates of those metals may include lithium, lithium fluoride, sodium oxide, lithium oxide and lithium carbonate. Examples of the metals other than Ca classified in Group 2 of the periodic table and having a work function of 1.5 to 3.0 eV, oxides, halides, or carbonates of those metals may include strontium, magnesium oxide, magnesium fluoride, strontium fluoride, barium fluoride, strontium oxide and magnesium carbonate.

### (Cathode)

The cathode as an electrode having light transparency may include inorganic semiconductors such as metals, graphite or graphite interlayer compounds and ZnO (zinc oxide), conductive transparent electrodes such as ITO (indium tin oxide) and IZO (indium zinc oxide), and metal oxides such as strontium oxide and barium oxide. Examples of the metals may include alkali metals such as lithium, sodium, potassium, rubidium and cesium; alkali earth metals such as beryllium, magnesium, calcium, strontium and barium; transition metals such as gold, silver, platinum, copper, manganese, titanium, cobalt, nickel and tungsten; and tin, aluminium, scandium, vanadium, zinc, yttrium, indium, cerium, samarium, europium, terbium and ytterbium; and alloys of two or more thereof. Examples of the alloys may include magnesium-silver alloy, magnesium-indium alloy, magnesium-aluminium alloy, indium-silver alloy, lithium-aluminium alloy, lithium-magnesium alloy, lithium-indium alloy and calcium-aluminium alloy. The cathode may be the layered structure having two or more layers. Examples thereof may include a stacked structure which is composed of the abovementioned metals, metal oxide, fluoride or the alloy thereof accompanied with metals such as aluminium, silver or chromium.

### EXAMPLES

Examples of the present invention are described below. The Examples indicated in below are the exemplifications suitable for explaining the present invention, and do not intend to limit the present invention.

The following Examples are the exemplifications when the light-emitting element is an organic EL element. In this organic EL element, as described previously, there is a case that those are simply arranged both sides of a light-emitting layer, and there is another case that in addition to the anode and the cathode, other electrode members such as a hole injection layer, a hole transport layer, an electron transport layer and an electron injection layer are variously combined and stacked onto the light-emitting layer, thereby forming the light-emitting unit. In the following Examples, the electrode members formed on both sides of the light-emitting layer are described simply, and it is obvious that they can be applied likewise even when the electrode members of any formation is formed on the light-emitting layer. That is, the electrode members of various combinations are formed on the light-emitting layer, and subsequently a multilayer sealing film is formed thereon. In the present invention, a formation in which the light-emitting layer is sealed with the multilayer sealing film means as described above.

### (Example 1)

### (Method for producing organic EL element)

The glass substrate, which had a patterned ITO film having the thickness of 150 nm formed by the sputtering method, was washed with an organic solvent, an alkaline detergent and ultrapure water, and dried, and then subjected to the UV-O₃ treatment (treatment of making lyophilic) using the UV-O₃ apparatus (trade name: Model 312 UV-O₃ Cleaning system supplied from Techno Vision Inc.).

A film having the thickness of 70 nm was formed on the ITO side of the substrate by coating the suspension obtained by filtrating the suspension of (3,4)ethylenedioxythiophene/polystyrene sulfonic acid (trade name: "Bytron P TP AI 4083" supplied from HC Starck V-Tech Ltd.) with the filter having the diameter of 0.5 µm by the spin coating method, and dried on the hotplate at 200°C for 10 minutes in atmospheric air.

Subsequently, a solution of the polymer organic light-emitting material (trade name: "Lumation BP361" supplied from Sumation) in the amount of 1.5% by mass was made using the solvent in which xylene and anisole had been mixed at 1:1. This solution was formed into the film having the thickness of 80 nm by the spin coating method on the substrate on which the film of "Bytron P" had been formed previously.

The light-emitting layer in the extraction electrode part and the sealing area part were removed, and the substrate was introduced into a vacuum chamber and transferred into a heating room-the subsequent process was conducted in vacuum or in nitrogen and the element during the process was not exposed to the atmospheric air. Subsequently, the substrate was heated in vacuum (vacuum degree was 1×10⁻⁴ Pa or less) at the temperature of about 100°C for 60 minutes.

Thereafter, the substrate was transferred into a deposition chamber, a cathode mask was aligned, and a cathode film was deposited so that the cathode film was formed on the light-emitting unit and the extraction electrode part. Ba metal was heated and deposited at the deposition rate of 2 angstroms/second by the resistance heating method as the cathode film having the thickness of 50 angstroms, and then using the electron beam deposition method, Al was deposited at the deposition rate of 2 angstroms/second as the cathode film having the thickness of 1500 angstroms.

### (Formation of organic/inorganic sealing film)

After forming the element, the substrate was transferred from the deposition chamber to a film sealing device (trade name: "Guardian 200" supplied from US VITEX) without being exposed to the atmosphere. A mask was aligned and set on the substrate. Then, the substrate was transferred into the inorganic film forming room, and the film of aluminium oxide was formed as the first organic layer by the sputtering method. The film of aluminium oxide was formed on the substrate by using an Al metal target with the purity of 5N and introducing argon gas and oxygen gas. The transparent and flat film of aluminium oxide having the thickness of about 60 c was obtained.

After forming the first inorganic layer film, the mask for the inorganic layer was removed and changed to a mask for the organic layer, and the substrate was transferred into an organic film forming room. Fluorescent pigment fine particles (trade name: "FA003" supplied from Sinloihi Co., Ltd.) in the amount of 20% by weight as the color conversion material were added to the organic monomer material (trade name: "Vitex Barix Resin System monomer material (Vitex 701)" supplied from VITEX), and introduced into the vaporizing chamber. The monomer containing the color conversion material was vaporized and the monomer vapor was sprayed out from a slit nozzle. The substrate was passed on the nozzle at a constant speed so that the thickness was uniform, thus applying the monomer on the substrate. Subsequently, the substrate on which the monomer had been applied was irradiated with UV light to crosslink and cure the monomer to form the first organic layer. The resulting film was transparent and flat and had the film thickness of 1.3 µm.

After forming the first organic layer, the substrate was transferred into the inorganic film forming room, and the film of aluminium oxide was formed as the second inorganic layer by the sputtering method by introducing argon and oxygen. The transparent and flat film of aluminium oxide having the thickness of about 40 nm was formed. The transparent and flat film of aluminium oxide having the thickness of about 40 nm was formed.

After forming the second inorganic layer, a film was formed as the second organic layer in the same manner as in the first organic layer. After forming the second organic layer, the third inorganic layer was formed in the same manner as in the second inorganic layer. Likewise, the third organic layer and the fourth inorganic layer were formed, thus obtaining the multilayer sealing film.

In the formation of the multilayer sealing film in the above Example 1, the first inorganic layer and the second inorganic layer correspond to a first film and a second film, respectively defined in the present invention. Likewise, the relation of the second inorganic layer and the third inorganic layer corresponds to a first film and a second film, respectively defined in the present invention. Further, the relation of the third inorganic layer and the fourth inorganic layer corresponds to a first film and a second film, respectively defined in the present invention. And thus, the color conversion layer (the first organic layer, the second organic layer and the third organic layer) is formed between the respective inorganic layers.

### (Example 2)

In the same manner as in Example 1, an organic EL element was made, and subsequently the element was transferred from the deposition chamber into the film sealing device (trade name: "Guardian 200" supplied from US VITEX) without exposing the element to the atmosphere. The mask was aligned and set on the substrate. Then, the substrate was transferred into the inorganic film forming room, and the film of aluminium oxide was formed as the first organic layer by the sputtering method. The film of aluminium oxide was formed on the substrate using the Al metal target with the purity of 5N and introducing the argon gas and the oxygen gas. The transparent and flat film of aluminium oxide having the thickness of about 60 nm was obtained.

Subsequently, the film of coumarin 6 (trade name: "coumarin 6" supplied from Aldrich), which was the color conversion material, was formed at the deposition rate of 2 angstroms/second by the vacuum deposition method, thus forming the color conversion layer having the film thickness of 1500 angstroms.

After forming the color conversion layer, the mask for the inorganic layer was removed and changed to the mask for the organic layer, and the substrate was transferred to the organic film forming room. The organic monomer material (trade name: "Vitex Barix Resin System monomer material (Vitex 701)" supplied from VITEX) was introduced into the vaporizing chamber. This monomer was vaporized and the monomer vapor was sprayed out from the slit nozzle. The substrate was passed on the nozzle at a constant speed so that the thickness was uniform to apply the monomer on the substrate. Subsequently, the substrate on which the monomer had been applied was irradiated with the UV light to crosslink and cure the monomer, thus forming a first organic layer. The resulting film was transparent and flat and had the film thickness of 1.3 µm.

After forming the first organic layer, the substrate was transferred into the inorganic film forming room, and the film of aluminium oxide was formed as the second inorganic layer by the sputtering method by introducing argon and oxygen. The transparent and flat film of aluminium oxide having the thickness of about 40 nm was formed.

After forming the second inorganic layer, the film of coumarin 6 was formed again at the deposition rate of 2 angstroms/second by the vacuum deposition method, thus forming the color conversion layer having the film thickness of 1500 angstroms. These steps were likewise repeated three times, and finally the film of the fifth inorganic layer was formed on the film of the fourth organic layer, thus obtaining the multilayer sealing film.

In the formation of the multilayer sealing film in the above Example 2, the first inorganic layer and the first organic layer correspond to a first film and a second film, respectively defined in the present invention. Likewise, the relation of the second inorganic layer and the second organic layer corresponds to a first film and a second film, respectively defined in the present invention, and the relation of the third inorganic layer and the third organic layer corresponds to a first film and a second film, respectively defined in the present invention. Further, the relation of the fourth inorganic layer and the fourth organic layer corresponds to a first film and a second film, respectively defined in the present invention. And, the color conversion layer composed of the coumarin layer is formed between each inorganic layer and each organic layer.

### (Comparative Example 1)

An organic EL element was obtained in the same manner as in the above Example 1, except that the color conversion material was not added in the organic monomer material that formed the organic layer in the above Example 1.

### (Measurement and measurement results of color conversion efficiency of multilayer sealing film)

Color tone change of extracted light in the organic EL elements produced in the above Examples 1 and 2 and Comparative Example 1 was measured, and yellowish blue-green light emission from the light-emitting layer was observed in Examples whereas blue color was observed in Comparative Example. In Example 1, the scattering effect derived from the fluorescent pigment particles acted synergistically and the extraction efficiency was enhanced.

### INDUSTRIAL APPLICABILITY

As described above, the light-emitting element according to the present invention is **characterized in that**: the light-emitting element comprises a light-emitting layer that is sealed at a light extracting side with a multilayer sealing film and the multilayer sealing film includes at least one color conversion layer. The method for producing the light-emitting element according to the present invention is **characterized in that**: the method for producing a light-emitting element that has a light-emitting layer sealed at a light extracting side with a multilayer sealing film, comprises forming at least one color conversion layer in a formation of the multilayer sealing film.

According to the light-emitting element of the present invention, the light-emitting element emits per se the desired colored light without adding extra optical elements. This is achieved by forming at least one color conversion layer in the multilayer sealing film at the light extracting side of the light-emitting layer. This color conversion layer is formed by containing the color conversion material in its matrix material; therefore, it can be easily formed as one layer in the multilayer sealing film. As the matrix material of this color conversion layer, the organic layer per se that forms the multilayer sealing film may be used, or the organic compound for newly forming the layer may be used; therefore, the color conversion layer is formed easily. When the colored optical film is used in the conventional procedure, the advanced laminating step and the optical film member are needed. However, in the method of the present invention, the color conversion layer can be formed through the ordinary steps of forming the multilayer sealing film; therefore, the process is simple, and it is possible to easily produce the light-emitting element from which the desired colored light can be extracted.

As described above, the light-emitting element and the method for producing the same of the present invention can inexpensively provide a light-emitting element from which the desired colored light can be extracted without increasing the occupied space thereof.

## Claims

1. A light-emitting element comprising a multilayer sealing film and a light-emitting layer that is sealed at a light extracting side thereof with the multilayer sealing film,
wherein the multilayer sealing film includes at least one color conversion layer.

2. The light-emitting element according to claim 1, wherein the multilayer sealing film includes at least one organic layer.

3. The light-emitting element according to claim 1, wherein the multilayer sealing film includes at least one first film and at least one second film.

4. The light-emitting element according to claim 3, wherein the color conversion layer is formed between the at least one first film and the least one second film.

5. The light-emitting element according to claim 1, wherein the color conversion layer comprises a matrix material and a color conversion material contained in the matrix material.

6. The light-emitting element according to claim 5, wherein the color conversion layer is the at least one first film containing the color conversion material.

7. The light-emitting element according to claim 5, wherein a content of the color conversion material in the color conversion layer is 0.01% to 90% by weight.

8. The light-emitting element according to claim 1, wherein the color conversion layer consist of a color conversion material.

9. The light-emitting element according to claim 5, wherein the color conversion material is composed of at least one selected from the group consisting of an inorganic phosphor, an organic pigment and a coloring matter.

10. The light-emitting element according to claim 8, wherein the color conversion material is composed of at least one selected from the group consisting of an inorganic phosphor, an organic pigment and a coloring matter.

11. The light-emitting element according to claim 3, wherein the first film is an organic film.

12. The light-emitting element according to claim 11, wherein the organic film is composed of an acrylic polymer.

13. The light-emitting element according to claim 3, wherein the second film is an inorganic film.

14. The light-emitting element according to claim 1, which is an organic EL element.

15. An illuminating device comprising the light-emitting element which is the organic EL element according to claim 14.

16. A method for producing a light-emitting element that has a light-emitting layer sealed at a light extracting side thereof with a multilayer sealing film, the method comprising:
forming at least one color conversion layer in a formation of the multilayer sealing film.

17. The method for producing the light-emitting element according to claim 16, wherein the multilayer sealing film includes at least one organic layer.

18. The method for producing the light-emitting element according to claim 16, wherein the multilayer sealing film is formed configured to include at least one first film and at least one second film.

19. The method for producing the light-emitting element according to claim 18, wherein the color conversion layer is formed between the at least one first film and at least one second film.

20. The method for producing the light-emitting element according to claim 16, wherein the color conversion layer is formed by containing a color conversion material in a matrix material of the color conversion layer.

21. The method for producing the light-emitting element according to claim 20, wherein the color conversion layer is formed by containing the color conversion material in the at least one first film.

22. The method for producing the light-emitting element according to claim 20, wherein an content amount of the color conversion material in the color conversion layer is adjusted within the range of 0.01% to 90% by weight in an entire amount of the color conversion layer.

23. The method for producing the light-emitting element according to claim 16, wherein the color conversion layer is formed from a color conversion material.

24. The method for producing the light-emitting element according to claim 20, wherein the color conversion material is at least one selected from the group consisting of an inorganic phosphor, an organic pigment and a coloring matter.

25. The method for producing the light-emitting element according to claim 23, wherein the color conversion material is at least one selected from the group consisting of an inorganic phosphor, an organic pigment and a coloring matter.

26. The method for producing the light-emitting element according to claim 18, wherein the first film is an organic film.

27. The method for producing the light-emitting element according to claim 26, wherein the organic film is formed from an acrylic polymer.

28. The method for producing the light-emitting element according to claim 18, wherein the second film is an inorganic film.

29. The method for producing the light-emitting element according to claim 16, wherein the light-emitting element is an organic EL element.
